(19) Europäisches Patentamt
European Patent Office
Office européen des brevets

(11) **EP 3 196 335 A1**

(12) **EUROPEAN PATENT APPLICATION**

(43) Date of publication:
**26.07.2017 Bulletin 2017/30**

(51) Int Cl.:
***C23C 16/24*** (2006.01)      ***C23C 16/455*** (2006.01)

(21) Application number: **17152489.5**

(22) Date of filing: **20.01.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **22.01.2016 US 201615004455**

(71) Applicant: **Silcotek Corp.
Bellefonte, Pennsylvania 16823 (US)**

(72) Inventors:
- **VEZZA, Thomas F.
State College, PA Pennsylvania 16801 (US)**

- **CONDO, Steven A.
Mill Hall, PA Pennsylvania 17751 (US)**
- **DESKEVICH, Nicholas Peter
Hollidaysburg, PA Pennsylvania 16648 (US)**
- **MATTZELA, James B.
Port Matilda, PA Pennsylvania 16870 (US)**
- **SILVIS, Paul H.
Port Matilda, PA Pennsylvania 16870 (US)**

(74) Representative: **Loock, Jan Pieter et al
Kutzenberger Wolff & Partner
Theodor-Heuss-Ring 23
50668 Köln (DE)**

(54) **DIFFUSION-RATE-LIMITED THERMAL CHEMICAL VAPOR DEPOSITION COATING**

(57)      Thermal chemical vapor deposition coated articles and thermal chemical vapor deposition processes are disclosed. The article includes a substrate and a thermal chemical vapor deposition coating on the substrate. The thermal chemical vapor deposition coating includes properties from being produced by diffusion-rate-limited thermal chemical vapor deposition. The thermal chemical vapor deposition process includes introducing a gaseous species to a vessel and producing a thermal chemical vapor deposition coating on an article within the vessel by a diffusion-rate-limited reaction of the gaseous species.

**FIG. 1**

## Description

FIELD OF THE INVENTION

The present invention is directed to thermal chemical vapor deposition. More particularly, the present invention is directed to diffusion-rate-limited thermal chemical vapor deposition coating.

BACKGROUND OF THE INVENTION

Reaction-rate limited thermal chemical vapor deposition ("CVD") is capable of being used to produce coatings with excellent properties that can be applied to a myriad of materials. However, reaction-rate limited thermal CVD can produce cosmetic effects and/or inconsistencies that are not desirable. For example, use of processing beads is a technique for producing reaction-rate limited thermal CVD coatings. Such beads can result in inconsistent thicknesses, for example, producing bead spots and/or dissimilar coloration. Likewise, high concentrations of gases for decomposition at pressures of greater than 1,000 Torr can result in similar undesirable effects.

Some techniques, such as plasma-enhanced chemical vapor deposition (PECVD) and/or sputtering, create additional issues. Such techniques can cause impingement on a coating and/or substrate. In addition, such techniques can cause damage or limit materials due to the presence of accelerated ions. Likewise, deposition techniques requiring high heat (for example, above 700°C) can result in numerous issues, such as, metallurgical and/or crystallographic impact on the substrate.

Depending upon the species and the deposition techniques, thicknesses can also produce issues. For example, in some techniques large thicknesses (for example, above 8,000 Angstroms, above 10,000 Angstroms, or 20,000 Angstroms) can undesirably result in flaking of a coating. Such flaking can be throughout a coating or can be localized based upon the lack of uniformity of thickness in some techniques.

Diffusion-rate-limited thermal chemical vapor deposition coating that shows one or more improvements in comparison to the prior art would be desirable in the art.

BRIEF DESCRIPTION OF THE INVENTION

In an embodiment, an article includes a substrate and a thermal chemical vapor deposition coating on the substrate. The thermal chemical vapor deposition coating includes properties from being produced by diffusion-rate-limited thermal chemical vapor deposition.

In another embodiment, a thermal chemical vapor deposition process includes introducing a gaseous species to a vessel and producing a thermal chemical vapor deposition coating on an article within the vessel by a diffusion-rate-limited reaction of the gaseous species.

Other features and advantages of the present invention will be apparent from the following more detailed description, taken in conjunction with the accompanying drawing which illustrates, by way of example, the principles of the invention.

BRIEF DESCRIPTION OF THE DRAWING

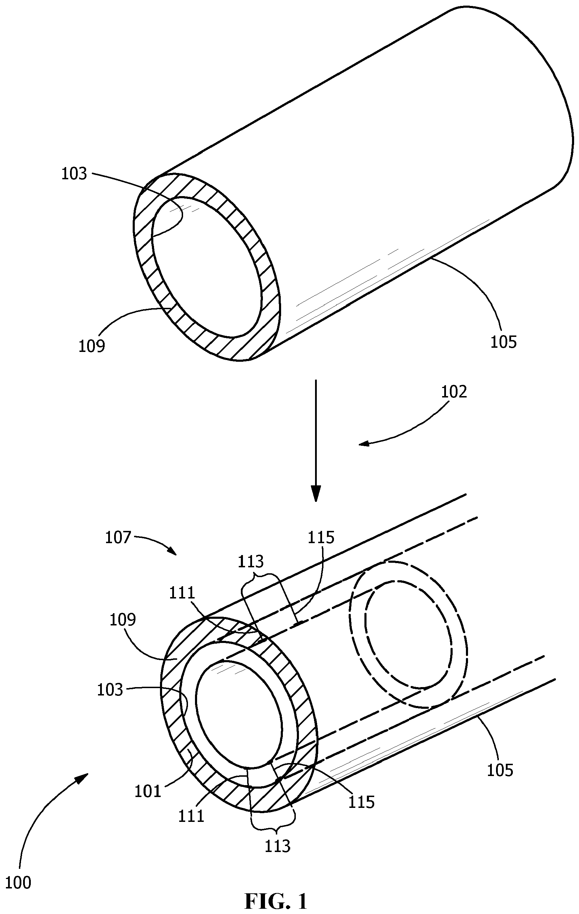

FIG. 1 is a schematic perspective sectioned view of diffusion-rate-limited thermal chemical vapor deposition coating process, according to an embodiment of the disclosure.

Wherever possible, the same reference numbers will be used throughout the drawing to represent the same parts.

DETAILED DESCRIPTION OF THE INVENTION

Provided are diffusion-rate-limited thermal chemical vapor deposition coated articles and coating proceses. Embodiments of the present disclosure, for example, in comparison to concepts failing to include one or more of the features disclosed herein, increase consistency/repeatability of coating, narrow range of thickness tolerances (for example, from 250 Angstroms to 150 Angstroms), improve aesthetics, permit processes to be achieved without using beads, modify film density, allow lower-temperature operation (for example, by over 10%), modify microstructure, modify optical properties, modify porosity, modify corrosion resistance, modify gloss, modify surface features, permit more efficient production of coatings, permit coating of a wide range of geometries (for example, narrow channels/tubes, three-dimensionally complex geometries, and/or hidden or non-line-of-site geometries, such as, in needles, tubes, probes, fixtures, complex planar and/or non-planar geometry articles, simple non-planar and/or planar geometry articles, and combinations thereof), permit coating of a bulk of articles, or permit a combination thereof

Referring to FIG. 1, a thermal chemical vapor deposition ("CVD") process 100 includes reacting one or more gases (step 102) in one or more steps within one or both of a vessel(s) 105 and/or chamber(s) to form a thermal CVD coating 101 on a surface 103 of an article 107. The article 107 shown in FIG. 1 is a tube that also serves as the vessel 105, the interior of which is the surface 103 coated with the thermal CVD coating 101. Additionally or alternatively, in other embodiments, the vessel(s) 105 and/or the chamber(s) are independent structures from the article 107 to be coated, such as a thermal oven chamber, an independent vessel structure, or any other structure having a finite volume that is configured to be at least temporarily enclosed (in contrast to flow-through arrangements used in other techniques).

Suitable dimensions for the vessel(s) 105 and/or chamber include, but are not limited to, having a minimum width of greater than 5 cm, greater than 10 cm, greater than 20 cm, greater than 30 cm, greater than 100 cm, greater than 300 cm, greater than 1,000 cm, between 10 cm and 100 cm, between 100 cm and 300 cm, between 100 cm and 1,000 cm, between 300 cm and 1,000 cm, any other minimum width capable of uniform or substantially uniform heating, or any suitable combination, sub-combination, range, or sub-range therein.

Suitable volumes for the vessel(s) 105 and/or chamber include, but are not limited to, at least 1,000 $cm^3$, greater than 3,000 $cm^3$, greater than 5,000 $cm^3$, greater than 10,000 $cm^3$, greater than 20,000 $cm^3$, between 3,000 $cm^3$ and 5,000 $cm^3$, between 5,000 $cm^3$ and 10,000 $cm^3$, between 5,000 $cm^3$ and 20,000 $cm^3$, between 10,000 $cm^3$ and 20,000 $cm^3$, any other volumes capable of uniform or substantially uniform heating, or any suitable combination, sub-combination, range, or sub-range therein.

As used herein, the phrase "thermal CVD" refers to a reaction and/or decomposition of one or more gases, for example, in a starved reactor configuration, and is distinguishable from plasma-assisted CVD, radical-initiated CVD, and/or catalyst-assisted CVD, sputtering, atomic layer deposition (which is limited to a monolayer molecular deposition per cycle in contrast being capable of more than one layer of molecular deposition), and/or epitaxial growth (for example, growth at greater than 700°C).

The surface 103 is a layer on a substrate 109 or is the substrate 109 itself. In one embodiment, the surface 103 is or includes a stainless steel surface (martensitic or austenitic), a nickel-based alloy, a metal surface, a metallic surface (ferrous or non-ferrous; tempered or non-tempered; and/or equiaxed, directionally-solidified, or single crystal), a ceramic surface, a ceramic matrix composite surface, a glass surface, ceramic matrix composite surface, a composite metal surface, a coated surface, a fiber surface, a foil surface, a film, a polymeric surface (such as, polyether etherketone), and/or any other suitable surface capable of withstanding operational conditions of the thermal chemical vapor deposition process 100.

In one embodiment, the surface 103 is treated. Suitable treatments include, but are not limited to, exposure to water (alone, with zero air, or with an inert gas), oxygen (for example, at a concentration, by weight, of at least 50%), air (for example, alone, not alone, and/or as zero air), nitrous oxide, ozone, peroxide, an elevated temperature, or a combination thereof. As used herein, the term "zero air" refers to atmospheric air having less than 0.1 ppm total hydrocarbons. The term "air" generally refers to a gaseous fluid, by weight, of mostly nitrogen, with the oxygen being the second highest concentration species within. For example, in one embodiment, the nitrogen is present at a concentration, by weight, of at least 70% (for example, between 75% and 76%) and oxygen is present at a concentration, by weight, of at least 20% (for example, between 23% and 24%).

In one embodiment, the elevated temperature of the treating of the surface 103 (and the substrate 105) is greater than 200°C, greater than 300°C, greater than 350°C, greater than 370°C, greater than 380°C, greater than 390°C, greater than 400°C, greater than 410°C, greater than 420°C, greater than 430°C, greater than 440°C, greater than 450°C, between 300°C and 450°C, between 350°C and 450°C, between 380°C and 450°C, or any suitable combination, sub-combination, range, or sub-range therein.

In one embodiment, the surface 103 is formed from a silane-based material, for example, formed from silicon hydride, silane, dimethylsilane (for example, in gaseous form), trimethylsilane, non-pyrophoric species (for example, dialkylsilyl dihydride and/or alkylsilyl trihydride), thermally-reacted material (for example, carbosilane and/or carboxysilane, such as, amorphous carbosilane and/or amorphous carboxysilane), species capable of a recombination of carbosilyl (disilyl or trisilyl fragments), and/or any other suitable silane-based material. Additionally or alternatively, in one embodiment, the surface 103 is formed from a thermally-reactive material, such as, silicon hydride, silicon nitride, ethylene, or a combination thereof Such silane-based materials and/or the thermally reactive materials are capable of being applied iteratively and/or with purges in between, for example, with an inert gas (such as, nitrogen, helium, and/or argon, as a partial pressure dilutant).

In one embodiment, the reacting of the one or more gases (step 102) to apply the thermal CVD coating 101 includes using gas(es) selected from the group consisting of silane, silicon hydride, dimethylsilane (for example, in gaseous form), trimethylsilane, dialkylsilyl dihydride, alkylsilyl trihydride, non-pyrophoric species (for example, dialkylsilyl dihydride and/or alkylsilyl trihydride), thermally reacted material (for example, carbosilane and/or carboxysilane, such as, amorphous carbosilane and/or amorphous carboxysilane), species capable of a recombination of carbosilyl (disilyl or trisilyl fragments), methyltrimethoxysilane, methyltriethoxysilane, dimethyldimethoxysilane, dimethyldiethoxysilane, trimethylmethoxysilane, trimethylethoxysilane, one or more nitrogen-containing species (for example, ammonia, nitrogen, hydrazine, trisilylamine (also known as, TSA; silanamine; N,N-disilyl-disilazane; 2-silyl-; silane, nitrilotris; or 3SA), Bis(tertiary-butylamino)silane, 1,2-bis(dimethylamino)tetramethyldisilane, and/or dichlorosilane, hexachlorodisilane), and combinations thereof. In embodiments with more than one species being introduced, the species are introduced concurrently (premixed or mixed in situ) or sequentially (with either species being introduced first).

In one embodiment, the one or more gases used in the reacting (step 102) is part of a gaseous mixture including thermally reactive gas(es) and an inert gas. Suitable concentrations of the thermally-reactive gas(es), by volume, are between 10% and 20%, between 10% and 15%, between 12% and 14%, between 10% and 100%, between 30% and 70%, between 500% and 80%, between 70% and 100%, between 80% and 90%, between 84% and 86%, or any suitable combination, sub-combination, range, or sub-range therein.

Suitable partial pressures for the gas(es) are between 10 Torr and 150 Torr, between 10 Torr and 30 Torr, between 20 Torr and 40 Torr, between 30 Torr and 50 Torr, between 60 Torr and 80 Torr, between 50 Torr and 100 Torr, between 50 Torr and 150 Torr, between 100 Torr and 150 Torr, less than 150 Torr, less than 100 Torr, less than 50 Torr, less than 30 Torr, or any suitable combination, sub-combination, range, or sub-range therein.

In one embodiment, the one or more gases are introduced to the vessel(s) 105 and/or the chamber through controlled flow to achieve the diffusion-rate-limited thermal chemical vapor deposition. Such control is capable through any suitable techniques and/or configurations, for example, via a flow restrictor (such as, with gaskets constricting to 5 micrometers from 20 micrometers, to 10 micrometers from 20 micrometers, to 5 micrometers from 10 micrometers or any suitable combination, sub-combination, range, or sub-range therein), mass flow controllers, pulses, valves, fritted gaskets, restrictors, or a combination thereof.

In another embodiment, the pressure and/or temperature are controlled/adjusted to achieve the diffusion-rate-limited thermal chemical vapor deposition. The reacting of the one or more gases (step 102) is within a temperature range to thermally react the gas(es) and facilitates deposition onto the surface 103. Suitable temperatures include, but are not limited to, between 100°C and 700°C, between 100°C and 450°C, between 100°C and 300°C, between 200°C and 500°C, between 300°C and 600°C, between 450°C and 700°C, 700°C, 450°C, 100°C, between 200°C and 600°C, between 300°C and 600°C, between 400°C and 500°C, 300°C, 400°C, 500°C, 600°C, or any suitable combination, sub-combination, range, or sub-range therein.

The reacting of the one or more gases (step 102) is within a pressure range facilitating the thermal reaction. Suitable pressures include, but are not limited to, between 0.01 psia and 200 psia, between 1.0 psia and 100 psia, between 5 psia and 40 psia, between 20 psia and 25 psia, 1.0 psia, 5 psia, 20 psia, 23 psia, 25 psia, 40 psia, 100 psia, 200 psia, or any suitable combination, sub-combination, range, or sub-range therein.

The reacting of the one or more gases (step 102) is within a period facilitating desired coverage of the surface 103. Suitable durations include, but are not limited to, at least 2 hours, at least 3 hours, at least 4 hours, at least 5 hours, at least 7 hours, between 4 and 10 hours, between 6 and 8 hours, or any suitable combination, sub-combination, range, or sub-range therein.

According to the disclosure, the article 107 coated by the thermal CVD process 100 includes properties by being produced by diffusion-rate-limited thermal CVD in contrast to reaction-rate limited thermal CVD. Through diffusion-rate-limited thermal CVD the properties capable of being produced include, but are not limited to, film density distinguishable from the film density that which would be produced by reaction-rate-limited thermal CVD, a thickness distinguishable from that which would be produced by reaction-rate-limited thermal CVD, a resistance to flaking above a certain thickness distinguishable from that which would be produced by reaction-rate-limited thermal CVD, a wavelength range narrower than that which would be produced by reaction-rate-limited thermal CVD, a wavelength that is different from that which would be produced by reaction-rate-limited thermal CVD, electronic impedance spectroscopy measurements distinguishable from the electronic impedance spectroscopy measurements of that which would be produced by reaction-rate-limited thermal CVD, a microstructure (for example, predominantly amorphous, substantially completely amorphous, or completely amorphous) that differs from that which would be produced by reaction-rate-limited thermal CVD, or a combination thereof.

In one embodiment, the thickness range of the diffusion-rate-limited thermal CVD applies the thermal CVD coating 101 within a suitable range 113, the range 113 being based upon the difference between a first thickness 111 and a second thickness 115, which individually and/or collectively resist flaking. Suitable ranges include, but are not limited to, 1,000 Angstroms, 500 Angstroms, 300 Angstroms, 200 Angstroms, 150 Angstroms, 100 Angstroms, 80 Angstroms, 50 Angstroms, or any suitable combination, sub-combination, range, or sub-range therein.

In one embodiment, the first thickness 111 and/or the second thickness 113 of the diffusion-rate-limited thermal CVD applies the thermal CVD coating 101 at a thickness of between 5,000 Angstroms and 30,000 Angstroms, between 5,000 Angstroms and 20,000 Angstroms, between 5,000 Angstroms and 10,000 Angstroms, between 10,000 Angstroms and 20,000 Angstroms, between 10,000 Angstroms and 15,000 Angstroms, between 15,000 Angstroms and 20,000 Angstroms, 8,000 Angstroms, 12,000 Angstroms, 16,000 Angstroms, 19,000 Angstroms, or any suitable combination, sub-combination, range, or sub-range therein.

In one embodiment, the diffusion-rate-limited thermal CVD applies the thermal CVD coating 101 to have a wavelength range of less than 10 nm, less than 20 nm, less than 30 nm, less than 40 nm, less than 50 nm, less than 100 nm, or any suitable combination, sub-combination, range, or sub-range therein. Suitable wavelengths subject to the wavelength ranges include, but are not limited to, 400 nm, 450 nm, 500 nm, 550 nm, 600 nm, 650 nm, 700 nm, or any suitable combination, sub-combination, range, or sub-range therein.

Although not intending to be bound by theory, in one embodiment, the diffusion-rate-limited thermal CVD is based upon flux to a surface ($J_1$), reaction flux ($J_2$), gas concentration ($C_g$), concentration on the surface ($C_s$), gas phase mass transport coefficient ($h_g$), and sur-

face reaction rate ($k_s$). In a further embodiment, the relationship is represented by the following equation:

$$v = \frac{C_g}{\dfrac{1}{h_G} + \dfrac{1}{k_S}}$$

According to this embodiment, the gas phase mass transport coefficient ($h_g$) is much greater than the surface reaction rate ($k_s$), resulting in the diffusion-rate-limited thermal CVD. For example, in an even further embodiment, the gas phase mass transport coefficient ($h_g$) is greater than the surface reaction rate ($k_s$) by a factor of at least 100, 200, 300, 400, 500, 600, 700, 800, 900, 1,000, or any suitable combination, sub-combination, range, or sub-range therein.

While the invention has been described with reference to one or more embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims. In addition, all numerical values identified in the detailed description shall be interpreted as though the precise and approximate values are both expressly identified.

**Claims**

1. Article (107), comprising:

   - a substrate (109); and
   - a thermal chemical vapor deposition coating (101) on the substrate (109);
   - wherein the thermal chemical vapor deposition coating (101) includes properties from being produced by diffusion-rate-limited thermal chemical vapor deposition.

2. Article (107) of claim 1, wherein the properties include a film density.

3. Article (107) of claim 1, wherein the properties include a thickness range of 1,000 Angstroms or less.

4. Article (107) of claim 1, wherein the thermal chemical vapor deposition coating (101) has a thickness of greater than 8,000 Angstroms, preferably greater than 12,000 Angstroms, particularly preferably greater than 16,000 Angstroms and most particularly preferably greater than 19,000 Angstroms, and does not flake.

5. Article (101) of claim 1, wherein the properties include a wavelength range of 100 nm or less.

6. Article (101) of claim 1, wherein the properties include impedance measurable by electronic impedance spectroscopy.

7. Article (101) of claim 1, wherein the properties include a predominantly amorphous structure.

8. Article (101) of claim 1, wherein the properties include a substantially completely amorphous structure.

9. Article (101) of claim 1, wherein the properties include growth that is not monolayer growth.

10. Article (101) of claim 1, wherein the properties include being devoid of bead spots.

11. Article (101) of claim 1, wherein the substrate (109) includes metal.

12. Article (101) of claim 1, wherein the substrate (109) includes a metallic alloy.

13. Article (101) of claim 1, wherein the substrate (109) has been treated by a temperature of at least 380°C, preferanly at least 430°C and particularly preferably of at least 440°C.

14. A thermal chemical vapor deposition process, comprising:

    - introducing a gaseous species to a vessel (105); and
    - producing a thermal chemical vapor deposition coating (101) on an article (101) within the vessel (105) by a diffusion-rate-limited reaction of the gaseous species.

15. Process of claim 14, wherein the gaseous species is a silane-containing species including silane at a concentration, by volume, of between 10% and 20% and an inert gas.

**FIG. 1**

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/064684 A1 (TODD MICHAEL A [US] ET AL) 24 March 2005 (2005-03-24) * paragraphs [0037] - [0039]; figures 10-12,15 * * paragraph [0052] * * paragraph [0074]; figure 15 * * paragraphs [0086], [0087] * ----- | 1-14 | INV. C23C16/24 C23C16/455 |
| X | US 4 792 460 A (CHU TING L [US] ET AL) 20 December 1988 (1988-12-20) * column 3, line 64 - line 66 * * column 6, line 7 - line 30; figure 2 * * column 1, line 8 - line 15 * ----- | 1-15 | |
| A | US 2002/045009 A1 (TOBASHI SHUJI [JP] ET AL) 18 April 2002 (2002-04-18) * page 3, paragraphs 44,46 * ----- | 15 | |
| X | GB 2 395 492 A (THERMO ELECTRON CORP [US]) 26 May 2004 (2004-05-26) * page 2, line 9 - page 3, line 33 * ----- | 1,14 | |
| | | | TECHNICAL FIELDS SEARCHED (IPC) C23C |

The present search report has been drawn up for all claims

| Place of search | Date of completion of the search | Examiner |
|---|---|---|
| The Hague | 13 June 2017 | Schuhmacher, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 15 2489

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2017

| Patent document cited in search report | | Publication date | Patent family member(s) | | Publication date |
|---|---|---|---|---|---|
| US 2005064684 | A1 | 24-03-2005 | AT | 400060 T | 15-07-2008 |
| | | | AU | 2002240403 A1 | 28-08-2002 |
| | | | AU | 2002306436 A1 | 15-10-2002 |
| | | | DE | 60223662 T2 | 30-10-2008 |
| | | | EP | 1374290 A2 | 02-01-2004 |
| | | | EP | 1374291 A2 | 02-01-2004 |
| | | | EP | 1421607 A2 | 26-05-2004 |
| | | | JP | 4224847 B2 | 18-02-2009 |
| | | | JP | 4417625 B2 | 17-02-2010 |
| | | | JP | 4866534 B2 | 01-02-2012 |
| | | | JP | 5134358 B2 | 30-01-2013 |
| | | | JP | 2004523903 A | 05-08-2004 |
| | | | JP | 2004525509 A | 19-08-2004 |
| | | | JP | 2004529496 A | 24-09-2004 |
| | | | JP | 2004532511 A | 21-10-2004 |
| | | | JP | 2005503000 A | 27-01-2005 |
| | | | JP | 2008098668 A | 24-04-2008 |
| | | | JP | 2008252104 A | 16-10-2008 |
| | | | JP | 2011228724 A | 10-11-2011 |
| | | | KR | 20030076675 A | 26-09-2003 |
| | | | KR | 20030076676 A | 26-09-2003 |
| | | | KR | 20030076677 A | 26-09-2003 |
| | | | KR | 20080104391 A | 02-12-2008 |
| | | | KR | 20090052907 A | 26-05-2009 |
| | | | US | 2002168868 A1 | 14-11-2002 |
| | | | US | 2002173113 A1 | 21-11-2002 |
| | | | US | 2002197831 A1 | 26-12-2002 |
| | | | US | 2003022528 A1 | 30-01-2003 |
| | | | US | 2003068851 A1 | 10-04-2003 |
| | | | US | 2003068869 A1 | 10-04-2003 |
| | | | US | 2003082300 A1 | 01-05-2003 |
| | | | US | 2005048745 A1 | 03-03-2005 |
| | | | US | 2005064684 A1 | 24-03-2005 |
| | | | US | 2005208740 A1 | 22-09-2005 |
| | | | US | 2005250302 A1 | 10-11-2005 |
| | | | US | 2007102790 A1 | 10-05-2007 |
| | | | US | 2008014725 A1 | 17-01-2008 |
| | | | US | 2008073645 A1 | 27-03-2008 |
| | | | US | 2010012030 A1 | 21-01-2010 |
| | | | WO | 02064853 A2 | 22-08-2002 |
| | | | WO | 02065508 A2 | 22-08-2002 |
| | | | WO | 02065516 A2 | 22-08-2002 |
| | | | WO | 02065517 A2 | 22-08-2002 |
| | | | WO | 02080244 A2 | 10-10-2002 |
| US 4792460 | A | 20-12-1988 | JP | H0559841 B2 | 01-09-1993 |

EPO FORM P0459

For more details about this annex : see Official Journal of the European Patent Office, No. 12/82

page 1 of 2

## ANNEX TO THE EUROPEAN SEARCH REPORT
## ON EUROPEAN PATENT APPLICATION NO.

EP 17 15 2489

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2017

| Patent document cited in search report | Publication date | Patent family member(s) | | Publication date |
|---|---|---|---|---|
| | | JP | S6321210 A | 28-01-1988 |
| | | US | 4792460 A | 20-12-1988 |
| US 2002045009 A1 | 18-04-2002 | JP | 4484185 B2 | 16-06-2010 |
| | | JP | 2002075875 A | 15-03-2002 |
| | | US | 2002045009 A1 | 18-04-2002 |
| GB 2395492 A | 26-05-2004 | AU | 2003285518 A1 | 18-06-2004 |
| | | GB | 2395492 A | 26-05-2004 |
| | | WO | 2004048639 A2 | 10-06-2004 |

EPO FORM P0459

For more details about this annex : see Official Journal of the European Patent Office, No. 12/82